# EUROPEAN PATENT APPLICATION

(11) **EP 2 804 284 A2**
(43) Date of publication of application: **19.11.2014**
(21) Application number: 13192067.0
(22) Date of filing: 08.11.2013
(51) Int. Cl.: H02J 7/00, H01M 10/48, H02J 7/04, H05K 1/14, H05K 1/18

(54) **Battery pack**

(30) Priority: 16.05.2013 US 201361824225 P; 28.08.2013 US 201314012980
(71) Applicant: Samsung SDI Co., Ltd., Yongin-si, Gyeonggi-do (KR)
(72) Inventor: Shin, Kyungjae, Yongin-si, Gyeonggi-do (KR); Kim, Kiwoong, Yongin-si, Gyeonggi-do (KR)
(74) Representative: Gulde & Partner

(57) **Abstract**

The invention relates to a battery pack (100) with at least one battery cell (120) and a protective circuit module (130) for protecting the battery cell (120) from over-charging or over-discharging. In order to be able to reliably sense a temperature of the battery cell (120), the protective circuit module (130) comprises a temperature sensitive element (150) that is thermally interconnected with the battery cell (120) by a flexible circuit board (140).

## Description

### [TECHNICAL FIELD]

The present invention relates to a battery pack with at least one battery cell, a protective circuit module for protecting the battery cell from over-charge or over-discharge, a temperature sensitive element for sensing the temperature of the battery cell, and a flexible printed circuit board that interconnects the battery cell and the protective circuit module.

### [BACKGROUND ART]

The protective circuit module used in the battery pack is configured such that a printed circuit pattern is formed on an insulating substrate and a plurality of semiconductor devices and a protection circuit are attached to the printed circuit pattern. In addition, in order to sense temperatures of the battery cells, a temperature sensitive element is attached to each of the battery cells and is electrically connected to the protective circuit module to transmit a signal indicating the measured temperature to the protective circuit module, thereby protecting the battery cells from over-charge or over-discharge. However, the process of electrically connecting the thermistor to the protective circuit module increases complexity in the assembling process of the battery as the temperature sensitive element cannot be automatically mounted on the battery cell. Furthermore, there exists the risk that the connection between the temperature sensitive element is interrupted during use of the battery.

### [TECHNICAL PROBLEM]

It is therefore an object the invention provide a battery pack, which can easily be assembled and which has a high operation safety.

### [TECHNICAL SOLUTION]

This object is achieved for the above mentioned battery according to the invention in that the protective circuit module comprises the temperature sensitive element and the flexible printed circuit board comprises a wiring pattern that thermally interconnects the battery cell and the temperature sensitive element.

For instance, the object may be realized by providing a battery pack including one or more battery cells; a protective circuit module provided at one side of the battery cells; a temperature sensitive element formed in the protective circuit module; and a flexible printed circuit board connected between the battery cells and the protective circuit module, wherein a wiring pattern of the flexible printed circuit board, which may be formed as a conductor path of the flexible printed circuit board, is thermally connected to the temperature sensitive element.

This simple solution provides that the temperature sensitive element, e.g. a temperature sensor, can be mounted to the protective circuit module, for instance on a printed circuit board of the protective circuit module, which may be populated with further components for protecting the battery cell. Mounting a component, in particular the temperature sensitive element, to a printed circuit board, can easily be done automatically, for instance by a mounting machine. Furthermore, as the temperature sensitive element is preferably affixed at and connected to the printed circuit boards by soldering, the mechanical and electrical connection between the temperature sensitive element and the printed circuit board is stable and reliable.

The solutions according to the invention can be combined as desired and further improved by the further following embodiments, which are advantageous on their own, in each case.

According to a first possible embodiment, the temperature sensitive element may be connected to an end of the wiring pattern, the end being attached to the protective circuit module. In particular, the temperature sensitive element can be in contact, preferably in direct contact with the end of the wiring pattern. The shorter the distance between the temperature sensitive element and the end of the wiring pattern, the better is the transfer of the heat from the battery cell to the temperature sensitive element. With a good transfer, the battery cell can be controlled and protected well.

In order to have a good thermal connection between the battery cell and the temperature sensitive element, the flexible printed circuit board is preferably formed with an insulation layer that covers the wiring pattern except for a contact region. With the contact region, the wiring pattern if the flexible printed circuit board can directly contact the battery cell and heat can be transferred from the battery cell to the wiring pattern with low thermal resistance.

A conductive pattern layer of the wiring pattern can thermally interconnect the battery cell and the temperature sensitive element. Thus, no additional pattern needs to be present in the flexible printed circuit board, which is dedicated to the thermal interconnection and which may increase costs of and installation space necessary for the flexible printed circuit board.

The conductive pattern layer may comprise a high current line, wherein the high current line thermally interconnects the battery cell and the temperature sensitive element. During charging of discharging of the battery cell, the high current line can conduct battery charging or discharging current. As a high current line capable of conducting battery charging or discharging currents needs to have a sufficient electrical conductivity, the high current line provides a low thermal resistance and efficiently conducts the heat from the battery cell to the temperature sensitive element.

The high current line may be formed as a plane conductor with at least one outer surface that is much wider than side surfaces interconnected by the outer surface. Due to the large outer surface, heat may be lost during the transfer by radiation or convection. In order to reduce heat loss, the conductive pattern layer may provide a sensing line, wherein the sensing line thermally interconnects the battery cell and the temperature sensitive element. The sensing line does not need to conduct high battery currents and may be provided to perform voltage measurements of electrical voltages applied to contact elements of the battery cell. Hence, an outer surface of the sensing line may be smaller than the outer surface to the high current line, resulting in less heat loss during transfer.

The insulation layer may cover the high current line or the sensing line except for a contact region in order to ensure a good thermal connection between the battery cell and the high current line or the sensing line.

According to another possible embodiment, the wiring pattern can comprise a dummy pattern that thermally interconnects the battery cell and the temperature sensitive element. The dummy pattern may by adapted to transfer the heat from the battery cell to the temperature sensitive element and may therefore more efficiently transfer the heat compared to the high current line or the sensing line.

In order to ensure that heat is not transferred between the dummy pattern and the high current line or the sensing line, which may affect the measurement of the temperature of the battery cell, the dummy pattern may be electrically independent from the conductive pattern layer.

To ensure a good thermal connection, the insulation layer may cover the dummy pattern except for a contact region.

A thermal conductive material, e.g. thermal grease or silicon may be provided on the contact region. In particular uneven areas of the battery cell can be well thermally contacted in case the thermal conductive material at least partially fills the unevenness.

The contact region is preferably in direct mechanical contact with the battery cell, as battery cells of have a regular and e.g. cylindrical form, which can easily be contacted extensively of the contact region.

Thus, the battery cell and the temperature sensitive element are preferably thermally interconnected, i.e. they are interconnected to transfer heat from the battery cell to the temperature sensitive element.

A thermal conductive material, e.g. thermal grease or silicon can be formed between the wiring pattern and the temperature sensitive element in order to improve thermal conductivity between the wiring pattern and the temperature sensitive element.

In case the flexible circuit board and the temperature sensitive element cannot be directly connected with each other, the protective circuit module may comprise a thermal conductive pattern that connects the wiring pattern, e.g. a connection terminal of the flexible printed circuit board, to the temperature sensitive element. The thermal conductive pattern may by a trace or a conducting track on a printed circuit board of the protective circuit module. The printed circuit board may the rigid.

The flexible printed circuit board is preferably adapted to allow movements of the battery cell relative to the temperature sensitive element. In particular, the printed circuit board may be installed such that the battery cell may move relative to the protective circuit module and its temperature sensitive element, thereby providing for a flexible electrical and thermal connection. As the temperature sensitive element is preferably fixed to the protective circuit module, movements of the battery cell do not affect the attachment if the temperature sensitive element.

Here, thermal grease or thermal silicon may be formed between the wiring pattern of the flexible printed circuit board and the temperature sensitive element.

In addition, the wiring pattern of the flexible printed circuit board and the temperature sensitive element are connected to each other through a thermally conductive pattern.

In the wiring pattern of the flexible printed circuit board, a sensing pattern, which may by a thermally conductive pattern, may be provided to transfer the heat generated from the battery cells to the temperature sensitive element.

In addition, an insulating layer is not present and e.g. removed from contact regions between the sensing pattern, and the battery cells and the contact regions may be exposed.

In addition, a dummy pattern electrically independent of the wiring pattern of the flexible printed circuit board may be provided to transfer the heat generated from the battery cells to the temperature sensitive element.

The temperature sensitive element may be provided as one of a positive temperature coefficient (PTC) thermistor and a negative temperature coefficient (NTC) thermistor.

### [ADVANTAGEOUS EFFECTS]

In the battery pack according to the present invention, conductive tabs of the battery cells and the protective circuit module are connected to the flexible printed circuit board to transfer the heat generated from the battery cells to the temperature sensitive element on the protective circuit module through wiring patterns of the flexible printed circuit board, thereby reducing the number of processes for forming the temperature sensitive element and achieving a stable connection between the temperature sensitive element and the battery cells, irrespective of movement of the battery cells.

In addition, in the battery pack according to the present invention, sensing lines of the flexible printed circuit board are partially exposed, or a separate dummy pattern is formed in the flexible printed circuit board to then be partially exposed. Therefore, the exposed region is brought into direct contact with the battery cells and the heat generated from the battery cells is transferred to the temperature sensitive element without a loss, thereby achieving accurate temperature measurement.

### [BRIEF DESCRIPTION OF THE DRAWINGS]

FIG. 1 is a perspective view of a battery pack according to an embodiment of the present invention coupled to an external device;
FIG. 2 is a perspective view of a battery pack according to an embodiment of the present invention;
FIG. 3 is an exploded perspective view of a battery pack according to an embodiment of the present invention;
FIG. 4 is a plan view illustrating a connection relationship between a flexible circuit board and a protective circuit board in a battery pack according to an embodiment of the present invention;
FIG. 5 is a cross-sectional view taken along the line A-A' of FIG. 2;
FIG. 6 is a plan view illustrating a connection relationship between a flexible circuit board and a protective circuit board in a battery pack according to another embodiment of the present invention; and
FIG. 7 is a plan view illustrating a connection relationship between a flexible circuit board and a protective circuit board in a battery pack according to still another embodiment of the present invention.

### [DETAILED DESCRIPTION FOR CARRYING OUT THE INVENTION]

Example embodiments will now be described more fully hereinafter with reference to the accompanying drawings.

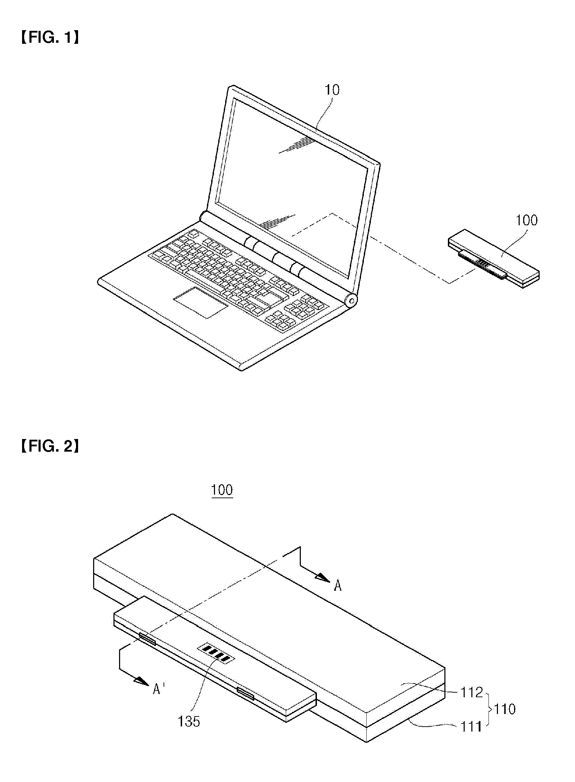

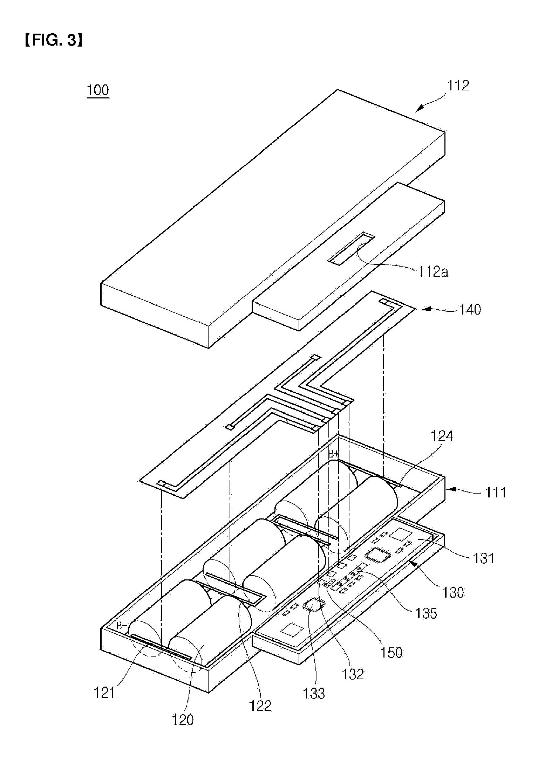

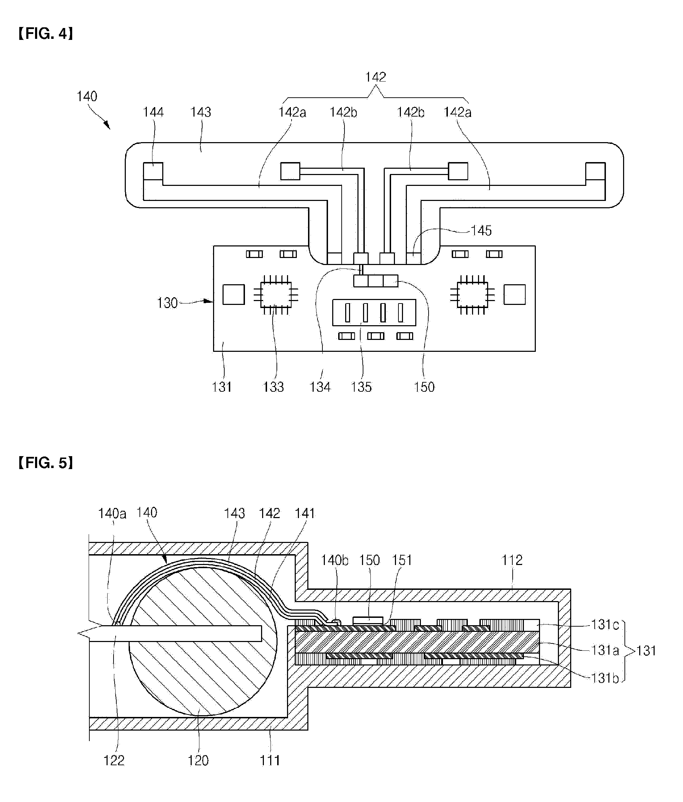

FIG. 1 is a perspective view of a battery pack according to an embodiment of the present invention coupled to an external device, FIG. 2 is a perspective view of a battery pack according to an embodiment of the present invention, FIG. 3 is an exploded perspective view of a battery pack according to an embodiment of the present invention, FIG. 4 is a plan view illustrating a connection relationship between a flexible circuit board and a protective circuit board in a battery pack according to an embodiment of the present invention, and FIG. 5 is a cross-sectional view taken along the line A-A' of FIG. 2.

First, referring to FIG. 1, the battery pack 100 according to the embodiment of the present invention is coupled to an external device, such as a notebook computer 10, to be used as a power source. While the battery pack 100 coupled to the notebook 10, for example, is illustrated in FIG. 1, it can be used in various kinds of devices, such as mobile phones or cameras, and a plurality of battery cells may be provided in the battery pack 100.

Referring to FIGS. 2 and 3, the battery pack 100 includes a case 110 comprising an upper shell 112 and a lower shell 111, a plurality of battery cells 120 provided in the case 110, a protective circuit module 130 electrically connected to the battery cells 120, a flexible printed circuit board 140 connecting the battery cells 120 and the protective circuit module 130, and a temperature sensitive element 150 provided in the protective circuit module130.

The case 110 accommodates the battery cells 120, the protective circuit module 130 and the flexible printed circuit board 140. The case 110 may comprise the lower shell 111 and the upper shell 112 coupled to each other.

The lower shell 111 is shaped of a box having an open top end surface to receive the battery cells 120, and a protruding part is further formed at one side of the lower shell 111 to receive the protective circuit module 130.

The upper shell 112 is coupled to an upper portion of the lower shell 111. The upper shell 112 is formed to correspond to the lower shell 111, and a protruding part is also formed at one side of the upper shell 112. The upper shell 112 is coupled to the lower shell 111, forming an external appearance of the battery pack 100.

The battery cells 120 are accommodated in the case 110. Rechargeable secondary batteries may be used as the battery cells 120. In the illustrated embodiment, the battery cells 120 are cylindrical batteries, but prismatic batteries may also be used according to the necessity. In addition, 6 battery cells 120 are exemplified. However, the present invention does not limit the number of battery cells and an appropriate number of battery cells may be provided according to the kind of external device.

The battery cells 120 may have different polarities at top and bottom surfaces thereof. The top surfaces of the battery cells 120 may be electrically connected to a positive electrode of an electrode assembly (not shown) in the cell, and the bottom surfaces of the battery cells 120 may be electrically connected to a negative electrode of the electrode assembly. In FIG. 3, reference symbols B+ and B- indicate high current terminals, corresponding to power supply units at opposite ends of the battery cells 120 connected to each other in series/parallel.

In addition, conductive tabs 121 may be connected between the battery cells 120. The conductive tabs 121 connect positive electrodes and negative electrodes of the battery cells 120 laterally adjacent to each other to establish parallel connections between the battery cells 120. In addition, the conductive tabs 121 are positioned between the battery cells 120 vertically adjacent to each other to establish serial connections between the battery cells 120. The conductive tabs 121 may be made of nickel (Ni), copper (Cu), aluminum (Al) and equivalents thereof, but aspects of the present invention are not limited thereto. In addition, each of the conductive tabs 121 is substantially 'U' shaped, so that the battery cells 120 are stably connected using elasticity, but aspects of the present invention are not limited thereto. However, the conductive tabs 121 may be simply plate-shaped.

The protective circuit module 130 is made to lie down at sides of the battery cells 120 to be installed to correspond to the case 110. That is to say, a bottom surface of the protective circuit module 130 is positioned to face the lower shell 111 of the case 110 and a top surface of the protective circuit module 130 is positioned to face the upper shell 112. The protective circuit module 130 is electrically connected to the battery cells 110 to control charging and discharging of the battery cells 110 and preventing the battery cells 110 from being over-charged or over-discharged.

The protective circuit module 130 is formed around a circuit board 131, e.g. a rigid printed circuit board, and a connection terminal 132 and at least one semiconductor device 133 are formed on one surface of the circuit board 131 to be connected to an external device through the connector 135. The semiconductor device 133 may comprise an integrated circuit that is adapted to compare the measured temperature of the battery cell with a limit value for allowable battery cell temperatures.

The circuit board 131 includes a wiring pattern 131 b formed on at least one surface of a planar insulating layer 131 a and an insulation pattern 131 c formed to surround a portion of the wiring pattern 131 b. Here, the insulating layer 131 a may be made of an insulating material, such as a reinforced fiber material or epoxy. In addition, the wiring pattern 131b may be made of an electrically conductive material, such as copper (Cu), titanium (Ti), nickel (Ni), or palladium (Pd), and the insulation pattern 131c may be made of an electrically insulating material, such as polyimide (PI) or polyethylene (PET) and may be formed on one surface of the insulating layer 131 a by, for example, printing. However, the present invention does not limit materials of the wiring pattern 131 b and the insulation pattern 131 c to those listed herein.

The connection terminal 132 may be formed by exposing a portion of the wiring pattern 131 b or by further providing a conductive material, such as gold (Au), on the exposed portion of the wiring pattern 131 b. The connection terminal 132 includes four connection terminals and may be connected to terminals of the flexible printed circuit board 140. The connection terminal 132 controls charging and discharging of the battery cells 120 through the flexible printed circuit board 140 under the control of the semiconductor device 133.

The semiconductor device 133 includes at least one semiconductor device formed on one surface of the circuit board 131 and applies signals for controlling operations of the battery cells 120. The semiconductor device 133 controls charging or discharging extents through high current lines of the battery cells 120. In addition, the semiconductor device 133 applies signals indicating voltages, current and temperatures of the battery cells 120 to prevent over-charge or over-discharge. To this end, the semiconductor device 133 applies information about the voltages and currents of the battery cells 120 from the flexible printed circuit board 140 through the connection terminal 132 and applies information about the temperatures of the battery cells 120 from the temperature sensitive element 150, and controls the operations of the battery cells 120. Here, the information about the voltages, currents and temperatures may be transferred to the semiconductor device 133 through the wiring pattern 131 b of the circuit board 131.

In particular, the circuit board 131 includes a thermally conductive pattern 134 separately provided on one surface of the circuit board 131 and may transfer heat of the battery cells 120 to the temperature sensitive element 150. Like the wiring pattern 131 b of the circuit board 131, the thermally conductive pattern 134 may be made of a material, such as copper (Cu), gold (Au), titanium (Ti), nickel (Ni), or palladium (Pd). The thermally conductive pattern 134 is connected to the flexible printed circuit board 140 and may transfer the heat from the battery cells 120 to the temperature sensitive element 150. Therefore, the temperature sensitive element 150, formed in the protective circuit module 130, can accurately measure temperatures of the battery cells 120 even in a state in which it is not in direct contact with the battery cells 120. Meanwhile, when the temperature sensitive element 150 comes into direct contact with the flexible printed circuit board 140, the thermally conductive pattern 134 may not be separately provided.

The flexible printed circuit board 140 extends between and is connected to the battery cells 120 and the protective circuit module 130. Since the flexible printed circuit board 140 is free from a bending operation, i.e. the flexible printed circuit board 140 can be easily bent, a stable connection may be maintained between the battery cells 120 and the protective circuit module 130 even if the battery cells 120 or the protective circuit module 130 move within the case 110.

The flexible printed circuit board 140 includes a first insulation layer 141, a conductive pattern layer 142, and a second insulation layer 143. In addition, the flexible printed circuit board 140 may further include a first connection terminal 144 and a second connection terminal 145 formed at opposite ends of the conductive pattern layer 142. Specifically, the first connection terminal 144 is exposed to exterior portions of the insulation layers 141 and 143 to be connected to the conductive tabs 121 of the battery cells 120. Here, the first connection terminal 144 and the conductive tabs 121 may be connected through a solder 140a, as shown in FIG. 5, or through a separate connector according to the option selected by one skilled in the art. In addition, the second connection terminal 145 is also exposed to exterior portions of the insulation layers 141 and 143 to be connected to the connection terminal 132 of the protective circuit module 130. Like in the first connection terminal 144, the second connection terminal 145 and the connection terminal 132 of the protective circuit module 130 may be connected through a solder 140b or a separate connector.

The first insulation layer 141 and the second insulation layer 143 may be formed as an insulating film made of, for example polyimide (PI) or polyethylene (PET).

In addition, the conductive pattern layer 142 may be made of an electrically conductive material, such as copper (Cu), gold (Au), titanium (Ti), nickel (Ni), or palladium (Pd), and may be formed on a top surface of the first insulation layer 141 to then be covered by the second insulation layer 143, thereby maintaining an electrically insulating state. The conductive pattern layer 142 may include a pair of high current lines 142a formed at the input/output terminals of the battery cells 120 and having relatively large widths, and a pair of sensing lines 142b connected between the battery cells 120 and having relatively small widths.

The high current lines 142a are connected to the protective circuit module 130 and may provide paths for applying charging/discharging currents of all of the battery cells 120. In addition, the high current lines 142a connected to the battery cells 120 may sense voltage and current signals of all of the battery cells 120 and may provide paths for transferring the sensed voltage and current signals to the protective circuit module 130.

The sensing lines 142b are connected to the conductive tabs 121 of the battery cells 120, except for the conductive tab 121 positioned at edge portions. The sensing lines 142b transmit voltage signals from connected portions of the battery cells 120 to the protective circuit module 130, thereby allowing the protective circuit module 130 to identify voltage values of the battery cells 120 connected in series. Here, the parallel-connected battery cells 120 are connected through the same conductive tabs 121 may have the same voltage value.

In addition, at least one of the sensing lines 142b may come into close contact with the battery cells 120. Therefore, the sensing lines 142b may be used as thermal conductors for the battery cells 120. Here, while the first insulation layer 141 are positioned between the sensing lines 142b and the battery cells 120, the sensing lines 142b may come into close contact with the battery cells 120 because the first insulation layer 141 has a relatively small thickness, and since the sensing lines 142b are good thermal conductors, the heat generated from the battery cells 120 may be transferred to the sensing lines 142b without a loss.

Once the heat from the battery cells 120 is transferred to the sensing lines 142b, the heat may be sequentially transferred to the second connection terminal 145 of the flexible printed circuit board 140 and the connection terminal 132 of the protective circuit module 130. In addition, the heat may be transferred from the connection terminal 132 to one end of the temperature sensitive element 150 through the thermally conductive pattern 134. Therefore, the heat from the battery cells 120 is sequentially transferred to the temperature sensitive element 150, the temperature sensitive element 150 may measure temperatures of the battery cells 120 even if it is physically separated from the battery cells 120. In addition, since the temperature sensitive element 150 is formed in the circuit board 131 of the protective circuit module 130 and is connected to the battery cells 120 through the flexible printed circuit board 140, movement of the battery cells 120 is dampened by the flexible printed circuit board 140, so that the temperature sensitive element 150 and the circuit board 131 may be maintained at a stably connected state.

Meanwhile, the high current lines 142a, instead of the sensing lines 142b, may be configured to function as thermal conductors for the battery cells 120, thereby transferring the heat to the temperature sensitive element 150. However, since the high current lines 142a have larger widths than the sensing lines 142b, a heat loss may be generated. Thus, the sensing lines 142b are preferably used as thermal conductors.

The temperature sensitive element 150 is provided on one surface of the circuit board 131 of the protective circuit module 130. The temperature sensitive element 150 is connected to the flexible printed circuit board 140 through the thermally conductive pattern 135, thereby measuring the temperatures of the battery cells 120.

The temperature sensitive element 150 may be a temperature sensor, for instance a negative temperature coefficient (NTC) thermistor, the electrical resistance value of which decreases due to a negative temperature coefficient as the temperature of the battery cells 120 increases, or a positive temperature coefficient (PTC) thermistor, the electrical resistance value of which increases as the temperature of the battery cells 120 increases. Since the temperature sensitive element 150 sensitively reacts to temperature and alters resistance values with temperature, the protective circuit module 130 may control charging and discharging of the battery cells 120.

Specifically, the temperature sensitive element 150 is provided as a chip thermistor and may be coupled to the protective circuit module 130. Since the chip thermistor is simply connected to the circuit board 131 of the protective circuit module 130 by a solder mounting process of mounting a solder 151, the number of overall process steps can be reduced. In addition, the solder mounting can be automated, and a jig for fixing the protective circuit module 130 is not separately required, thereby simplifying the manufacturing process.

In addition, the temperature sensitive element 150 may also be directly connected to the second connection terminal 145 connected to the sensing lines 142b of the flexible printed circuit board 130 through thermal grease or thermal silicon without passing through the thermally conductive pattern 134 of the protective circuit module 130. In this case, since the thermally conductive pattern 134 does not to be provided, a simplified heat transfer path can be formed, thereby achieving accurate measurement.

Hereinafter, a configuration of a battery pack according to another embodiment of the present invention will be described.

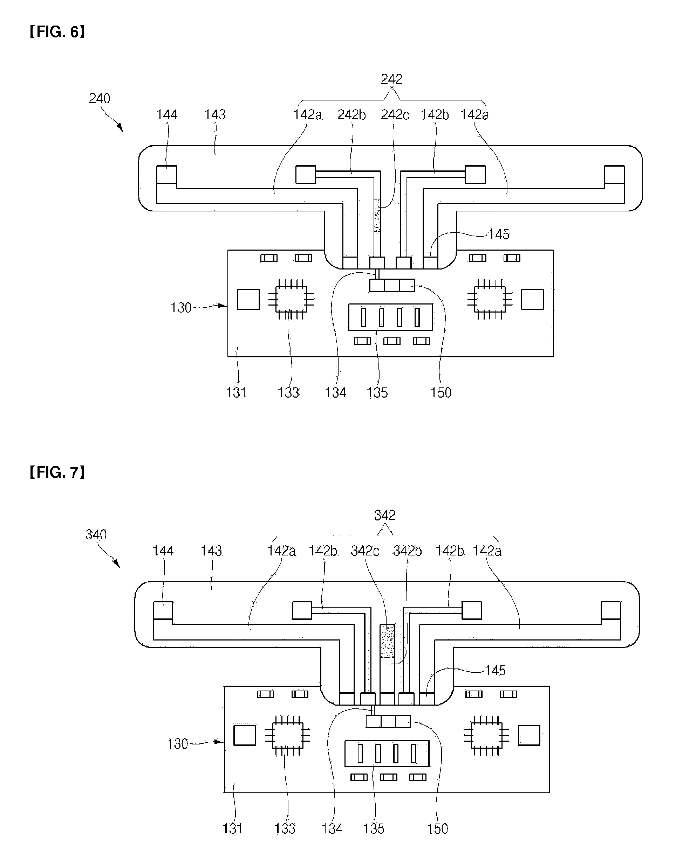

FIG. 6 is a plan view illustrating a connection relationship between a flexible circuit board and a protective circuit board in a battery pack according to another embodiment of the present invention. Here, the same structural and functional components as those of the previous embodiment are denoted by the same reference numerals, and the following description will focus on differences between the present and previous embodiments.

Referring to FIG. 6, in the battery pack according to another embodiment of the present invention, a flexible printed circuit board 240 includes a pair of sensing lines 242b. Here, at least one of the sensing lines 242b includes an exposed region 242c formed by removing a portion of the first insulation layer 141 and exposed to a bottom surface of the flexible printed circuit board 240. In addition, the exposed region 242c is provided to make direct contact with the battery cells 120. Hence, the exposed region 242c may form a contact region of the flexible printed circuit board 240 may therefore be designated as contact region, in particular in case that the flexible printed circuit board 240 reached into the battery pack 100 and rests against the battery cell 120 with its exposed region 242c. In addition, thermal grease or thermal silicon may further be formed between the flexible printed circuit board 240 and the exposed region 242c according to the option selected by one skilled in the art. Therefore, the sensing lines 242b may apply the heat from the battery cells 120 without a loss, thereby allowing the temperature sensitive element 150 connected to the sensing lines 242b to measure the temperatures of the battery cells 120 more accurately.

Hereinafter, a configuration of a battery pack according to still another embodiment of the present invention will be described.

FIG. 7 is a plan view illustrating a connection relationship between a flexible circuit board and a protective circuit board in a battery pack according to still another embodiment of the present invention.

Referring to FIG. 7, in the battery pack according to still another embodiment of the present invention, a flexible printed circuit board 340 includes high current lines 142a, sensing lines 142b, and a dummy line 342b formed independent of the high current lines 142a and sensing lines 142b. The dummy line 342b may by part of a dummy pattern of the flexible printed circuit board 240 and may have the same width as the sensing lines 142b and is electrically independent from the battery cells 120 without being connected to a first connection terminal 144. In addition, the dummy line 342b may include an exposed region 342c formed by removing at least a portion of the first insulation layer 141. The exposed region 342c makes direct contact with the battery cells 120 and may apply the heat directly from the battery cells 120. In addition, thermal grease or thermal silicon having good thermal conductivity may further be formed in the exposed region 342c, thereby more efficiently transferring the heat generated from the battery cells 120.

The dummy line 342b just applies the heat from the battery cells 120 without inputting/outputting electrical signals of the battery cells 120 and transfers the heat to the temperature sensitive element 150 through the second connection terminal 145. Therefore, since the heat is transferred through the dummy line 342b independent of the high current lines 142a and the sensing lines 142b, it is possible to reduce a heat loss, which may be generated in the course of transferring the heat through the electrical signals through the high current lines 142a and the sensing lines 142b or transferring the heat through the dummy line 342b.

## Claims

1. Battery pack (100) with at least one battery cell (120), a protective circuit module (130) for protecting the battery cell (120) from over-charge or over-discharge, a temperature sensitive element (150) for sensing the temperature of the battery cell (120), and a flexible printed circuit board (140) that interconnects the battery cell (120) and the protective circuit module (130), **characterized in that** the protective circuit module (130) comprises the temperature sensitive element (150) and the flexible printed circuit board (140) comprises a wiring pattern that thermally interconnects the battery cell (120) and the temperature sensitive element (150).

2. Battery pack (100) according to claim 1, **characterized in that** the temperature sensitive element (150) is connected to an end of the wiring pattern, the end being attached to the protective circuit module (130).

3. Battery pack (100) according to claim 1 or 2, **characterized in that** the flexible printed circuit board (140) is formed with an insulation layer (141) that covers the wiring pattern except for a contact region.

4. Battery pack (100) according to any of claims 1 to 3, **characterized in that** a conductive pattern layer (142) of the wiring pattern thermally interconnects the battery cell (120) and the temperature sensitive element (150).

5. Battery pack (100) according to claim 4, **characterized in that** the conductive pattern layer (142) comprises a high current line (142a), wherein the high current line (142a) thermally interconnects the battery cell (120) and the temperature sensitive element (150), or that the conductive pattern layer (142) comprises a sensing line (142b), wherein the sensing line (142b) thermally interconnects the battery cell (120) and the temperature sensitive element (150).

6. Battery pack (100) according to claim 5, **characterized in that** the insulation layer (141) covers the high current line (142a) or the sensing line (142b) except for a contact region.

7. Battery pack (100) according to any of claims 1 to 6, **characterized in that** the wiring pattern comprises a dummy pattern that thermally interconnects the battery cell (120) and the temperature sensitive element (150).

8. Battery pack (100) according to claim 7, **characterized in that** the dummy pattern is electrically independent from the conductive pattern layer (142).

9. Battery pack (100) according to claim 7 or 8, **characterized in that** the insulation layer (141) covers the dummy pattern except for a contact region.

10. Battery pack (100) according to any of claims 3 to 9, **characterized in that** thermal grease or silicon is provided on the contact region.

11. Battery pack (100) according to any of claims 3 to 9, **characterized in that** the contact region is in direct contact with the battery cell (120).

12. Battery pack (100) according to any of claims 1 to 11, **characterized in that** the battery cell (120) and the temperature sensitive element (150) are thermally interconnected.

13. Battery pack (100) according to any of claims 1 to 12, **characterized in that** thermal grease or silicon is formed between the wiring pattern and the temperature sensitive element (150).

14. Battery pack (100) according to any of claims 1 to 13, **characterized in that** the protective circuit module (130) comprises a thermally conductive pattern (134) that connects the wiring pattern to the temperature sensitive element (150).

15. Battery pack (100) according to any of claims 1 to 14, **characterized in that** the flexible printed circuit board (140) is adapted to allow movements of the battery cell (120) relative to the temperature sensitive element (150).
